# FASCICULE DE BREVET EUROPEEN

(11) **EP 1 030 184 B1**
(45) Date de publication et mention de la délivrance du brevet: **27.10.2004**
(21) Numéro de dépôt: 00400421.4
(22) Date de dépôt: 15.02.2000
(51) Int. Cl.: G01R 29/02, G01T 1/24, G01R 19/00, G01J 11/00

(54) **Analyseur d'impulsion de rayonnement unique et brève**
Analysator eines einzelnen kurzen Strahlungspulses
Analyzer for a short and single radiation pulse

(30) Priorité: 17.02.1999 FR 9901922
(43) Date de publication de la demande: 23.08.2000
(73) Titulaire: COMMISSARIAT A L'ENERGIE ATOMIQUE, 75752 Paris Cédex 15 (FR)
(72) Inventeur: Ghis, Anne, 38400 Saint-Martin D'heres (FR); Gentet, Marie Claude, 38920 Crolles (FR)
(74) Mandataire: Poulin, Gérard

(56) Documents cités:
- EP-A- 0 893 705
- WO-A-93/13427
- FR-A- 2 766 576
- US-A- 5 471 162

## Description

### Domaine de l'invention

L'invention concerne un analyseur d'impulsion de rayonnement unique et brève permettant de mesurer cette impulsion de rayonnement. Cette mesure d'impulsion peut s'appliquer à différents types de rayonnements : rayons x ou infrarouges, rayonnements visibles ou énergie électromagnétique.

L'invention trouve ainsi des applications dans tous les domaines nécessitant la mesure d'une impulsion de rayonnement non répétitive et très brève, et en particulier pour la mesure d'événements, générés par des phénomènes picosecondes.

### Etat de la technique

D'une façon générale, la métrologie d'impulsions permet de décrire l'évolution temporelle d'un signal électrique, en particulier de sa tension ou de son énergie, lorsque ce signal est unique (c'est-à-dire non répétitif), et très bref (c'est-à-dire d'une durée de l'ordre de quelques nanosecondes).

Un tel signal à mesurer provient généralement de détecteurs de rayonnements très rapides, qui convertissent, en signaux électriques, l'énergie d'une impulsion de rayonnement qu'ils ont reçue. De tels rayonnements peuvent être émis par des sources de rayonnements ultra rapides, telles que des lasers ou des sources de rayonnement synchrotron, ou peuvent être le résultat d'une interaction rayonnements-matière provoquée, par exemple, par un laser ultra rapide (c'est-à-dire dont la durée de l'impulsion est de l'ordre de quelques picosecondes jusqu'à quelques nanosecondes) .

Il existe actuellement, sur le marché, des appareils pour analyser de tels signaux monocoup (ou impulsions électriques) dont le spectre s'étend jusqu'à 2 GHz. Ces appareils sont commercialisés notamment par INTERTECHNIQUE, TEKTRONIX®, HP®, LECROY®, etc.

Pour mesurer des impulsions électriques à plus large bande et répétitives, il existe des oscilloscopes à échantillonnage qui peuvent mesurer des signaux dont le spectre s'étend jusqu'à 50 ou 70 GHz.

Or, dans certains cas, en particulier lors d'expériences de type rayonnement-matières, les énergies nécessaires pour fournir des impulsions de rayonnement sont très importantes. Ces expériences ne peuvent pas être répétées ; ce sont des expériences à caractère non-répétitif.

Le document WO 93 13427 A décrit un analyseur d'impulsion rapide où une impulsion électrique est modulée avec un signal optique. Le signal modulé est reproduit un certain nombre de fois, chacun des signaux ayant un délai différent. Ensuite chacun desdits signaux est soumis à un échantillonnage et à une analyse afin de reconstruire l'impulsion initiale.

Il existe actuellement des appareils pour mesurer des impulsions uniques, comme celui décrit dans la demande de brevet US-A-5 471 162. Cependant, pour mesurer des impulsions de rayonnement, cet appareil de mesure d'impulsions électriques doit être associé à des détecteurs de rayonnements. Cette association se fait au moyen de câbles et de connecteurs divers.

Or, ces détecteurs, câbles, connecteurs et appareils de mesure ont chacun leurs propres caractéristiques et bande passante, leurs propres impédances plus ou moins bien adaptées à l'ensemble et leur propre temps de montée. Le signal électrique est alors altéré par ces transitions successives.

De plus, dans le cas où l'appareil de mesure est basé sur le principe de l'échantillonnage spatial, le signal électrique est altéré différemment à l'intérieur de l'appareil, selon le point de mesure.

### Exposé de l'invention

L'invention a justement pour but de remédier aux inconvénients énoncés précédemment.

A cette fin, elle propose un analyseur d'impulsion de rayonnement unique comprenant à la fois des détecteurs de rayonnement qui convertissent ces rayonnements en signal électrique et des moyens de mesure de ce signal, par échantillonnage à différents instants, sans étalement spatial du signal.

De façon plus précise, l'invention concerne un analyseur d'impulsion de rayonnement unique qui comporte :
- une pluralité de détecteurs de rayonnement aptes à recevoir l'impulsion de rayonnement et à la transformer en une pluralité de signaux électriques ;
- une pluralité de moyens d'échantillonnage, reliés chacun à l'un des détecteurs de rayonnement et aptes à échantillonner, à des instants différents, le signal électrique issu des détecteurs ;
- des moyens de retard reliés chacun à un moyen d'échantillonnage pour retarder d'un intervalle de temps (dt) l'instant d'échantillonnage entre deux moyens d'échantillonnage ;
- des moyens de stockage associés chacun à un moyen d'échantillonnage pour stocker les informations issues desdits moyens d'échantillonnage ; et
- des moyens de lecture et de traitement de ces informations.

Les signaux électriques peuvent être échantillonnés à autant d'instants différents qu'il y a de moyens d'échantillonnage.

Avantageusement, les détecteurs sont associés sous forme d'un réseau à deux faces, polarisé par une électrode commune sur une face et une électrode individuelle centrale sur l'autre face.

Selon un mode de réalisation de l'invention, les détecteurs forment un réseau carré, adressé séquentiellement en lignes et en colonnes.

Selon un autre mode de réalisation de l'invention, les détecteurs forment un réseau en spirale, adressé à partir du centre du réseau.

### Brève description des dessins

- La figure 1 représente schématiquement le dispositif de l'invention, selon une vue de dessus ;
- la figure 2 représente schématiquement le dispositif de l'invention selon une vue en coupe, avec le réseau de détecteurs et les moyens de traitement de chaque impulsion électronique ; et
- les figures 3 et 4 représentent chacune un mode de réalisation du réseau de détecteurs.

### Description détaillée de modes de réalisation de l'invention

L'invention concerne un analyseur d'impulsion de rayonnement unique du type monocoup, c'est-à-dire capable de mesurer, en une seule fois, des impulsions de rayonnement très brèves.

Cet analyseur comporte, d'une part, une pluralité de détecteurs, associés ensemble pour recevoir les impulsions de rayonnement et transformer ces impulsions de rayonnement en impulsions électriques. Il comporte, d'autre part, un circuit électronique assurant l'échantillonnage et le traitement de ces impulsions électriques. Ce circuit comporte une pluralité d'échantillonneurs dont le rôle est de mesurer et de traiter les impulsions électroniques fournies par les détecteurs. Plus précisément, le circuit électronique comporte autant d'échantillonneurs qu'il y a de détecteurs, chaque échantillonneur étant directement connecté à un détecteur.

En d'autres termes, l'analyseur d'impulsion de rayonnement unique de l'invention intègre, à la fois, la conversion de l'énergie de rayonnement en énergie électrique et l'échantillonnage de l'impulsion électrique à différents instants. Ceci constitue un avantage de l'invention.

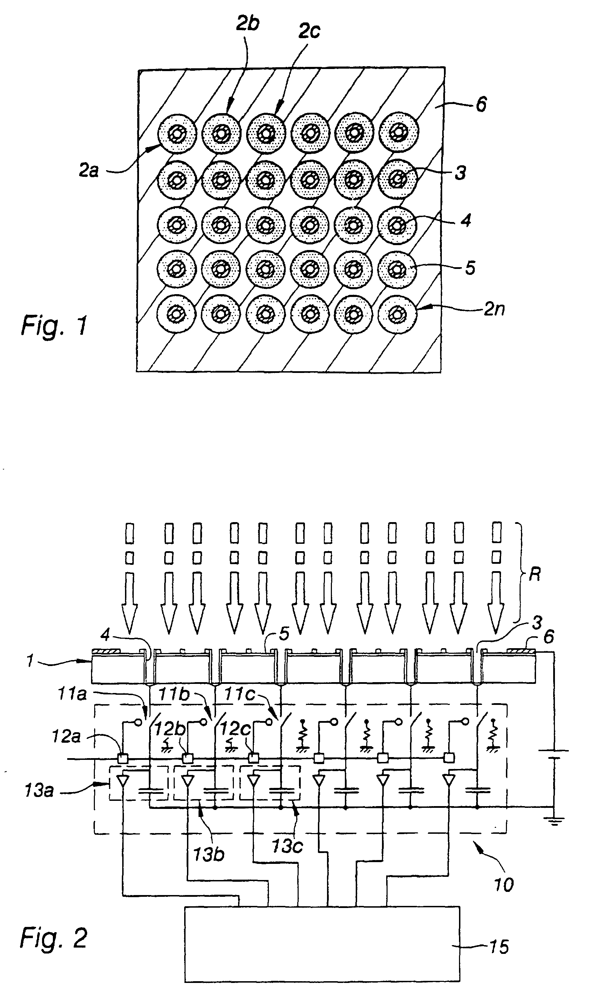

Sur la figure 1, on a représenté l'analyseur de l'invention selon une vue de dessus. Autrement dit, cette figure montre un exemple de réseau de détecteurs utilisé dans l'analyseur d'impulsion de rayonnement unique conforme à l'invention. Ce réseau de détecteurs, référencé 1, est constitué d'une pluralité de détecteurs référencés 2a, 2b, 2c, etc., 2n.

Plus précisément, ce réseau comporte un substrat, par exemple en saphir, perforé de trous, référencés 3, dont les parois, le bord et le fond sont recouverts d'un matériau conducteur 4. Le substrat est recouvert d'une couche de matériau photoconducteur 5, tel que du CdTe ou du GaAs, puis d'un dépôt de matériau conducteur 6, tel que de l'or. Ce dépôt de matériau conducteur est réalisé de façon à laisser un anneau de matériau photoconducteur 5 non recouvert autour de chaque trou et représenté, sur la figure 1, par des « mouchetés ». Les matériaux conducteurs 4 et 6 sont avantageusement identiques. Ils sont représentés, sur la figure 1, par des hachures.

On réalise ainsi un réseau d'anneaux détecteurs que l'on polarise concentriquement par une électrode collective, réalisée par la couche de matériau conducteur 6, et par une électrode individuelle centrale, placée sur l'autre face du substrat.

Le réseau de détecteurs, représenté sur la figure 1, est un exemple de réseau dans lequel les détecteurs sont placés en lignes et en colonnes et polarisés collectivement sur la face supérieure, par le matériau conducteur 6, et individuellement sur l'autre face du réseau par le matériau conducteur 4.

Les détecteurs qui viennent d'être décrits sont rapides, c'est-à-dire qu'ils ont un temps de réponse court. Ces détecteurs fonctionnent en photoconduction et leur géométrie est adaptée à la tension de polarisation. Celle-ci est déterminée en fonction des caractéristiques des échantillonneurs et de l'énergie du rayonnement à mesurer. On a donc Iₛ(t) = Vₚₒₗ/R, où Iₛ(t) est l'intensité du signal à un instant t, Vₚₒₗ est la tension de polarisation et R est la résistance sous éclairement pour l'énergie incidente d'impulsion.

Sur la figure 2, on a représenté l'analyseur d'impulsions de rayonnement de l'invention, selon une vue de côté, en coupe. Cette figure 2 montre le réseau de détecteurs de la figure 1, associé au circuit électronique d'échantillonnage et de mesure des signaux électriques fournis par le réseau de détecteurs.

De façon plus précise, on a schématisé sur la figure 2 les rayonnements incidents R arrivant sur la surface du réseau de détecteurs 1.

Le réseau de détecteurs 1 transforme ces rayonnements en impulsions électriques et les transmet au circuit d'échantillonnage et de mesure 10, qui peut être un circuit intégré. Ce circuit 10 comporte une matrice d'échantillonneurs 11a, 11b,..., chaque échantillonneur étant connecté directement à l'un des détecteurs du réseau 1. A chaque échantillonneur est également associée une résistance connectée à la masse. Cette résistance est une résistance d'évacuation dont le rôle est d'empêcher le détecteur de se charger pendant l'intervalle de temps où le signal n'est pas échantillonné. Le signal électrique fourni par chaque détecteur est donc introduit directement dans un échantillonneur.

En d'autres termes, l'impulsion de rayonnement est reçue en intégralité par chacun des détecteurs qui transforment cette impulsion de rayonnement en impulsions électriques. Chacune de ces impulsions électriques est échantillonnée par un échantillonneur, l'ensemble des échantillonneurs étant activé l'un après l'autre avec un pas temporel prédéterminé dt. Autrement dit, chaque échantillonneur échantillonne, à un instant différent, une partie du signal électrique correspondant à l'impulsion de rayonnement reçue simultanément par tous les détecteurs. Ce retard temporel dans la propagation du signal d'échantillonnage, entre les différents échantillonneurs 11a, 11b, etc., est réalisé au moyen de circuits de retard 12a, 12b, etc. Ces circuits de retard 12a, 12b,..., appelés aussi « circuits de distribution contrôlée de l'ordre d'échantillonnage », assurent une distribution contrôlée de l'ordre d'échantillonnage en retardant d'un instant dt le signal entre deux échantillonneurs.

Des moyens de stockage 13a, 13b, etc. sont associés à chaque échantillonneur 11a, 11b, etc. de façon à mémoriser les informations issues des détecteurs et à les amplifier pour les envoyer vers un système 15 de lecture et de traitement des informations.

Ainsi, le circuit d'échantillonnage et de mesure 10 comporte, pour chaque détecteur du réseau 1, un échantillonneur 11 associé à un circuit de distribution contrôlée 12 et à des moyens de stockage 13. Chaque échantillonneur a donc ses propres moyens de commande et de synchronisation.

L'implantation géométrique de ces éléments 11, 12, 13 sur ce circuit d'échantillonnage et de mesure 10 respecte l'implantation géographique du réseau de détecteurs 1.

Le réseau de détecteurs 1 et le circuit 10 sont connectés par la face arrière du réseau de détecteurs et la face avant de la matrice d'échantillonneurs, par un réseau de microconnexion.

Par exemple, pour réaliser la mesure temporelle d'une impulsion de rayonnement unique, en 100 points, il faut réaliser un réseau de 100 détecteurs, le plus compact possible. En effet, un réseau de détecteurs compact permet une utilisation maximale de la surface du faisceau de rayonnement, de façon à obtenir la meilleure sensibilité de mesure possible. Il faut ensuite connecter ces 100 détecteurs au plus près avec 100 échantillonneurs, chaque détecteur étant relié à un échantillonneur par un circuit de distribution contrôlée de l'ordre d'échantillonnage, référencé 12 sur la figure 2.

Il est à noter que le dispositif de l'invention peut comporter un nombre de points variable en fonction des besoins. Dans l'exemple représenté sur les figures 1 et 2, l'analyseur permet une mesure en 30 points.

L'analyseur d'impulsion de rayonnement unique de l'invention a l'avantage de permettre un échantillonnage de l'impulsion électrique à différents instants, sans étalement spatial de l'impulsion électrique, donc sans propagation. L'absence d'étalement spatial de l'impulsion implique que la fonction de transfert est homogène pour les différents points d'échantillonnage.

De plus, cet analyseur est réalisé, sans connectique intermédiaire, ce qui permet de minimiser la distorsion du signal électrique.

Selon ce dispositif, l'énergie du signal à mesurer est répartie sur l'ensemble des détecteurs ; cette énergie doit donc être suffisante pour irradier de façon significative tous les détecteurs du réseau de détecteur 1.

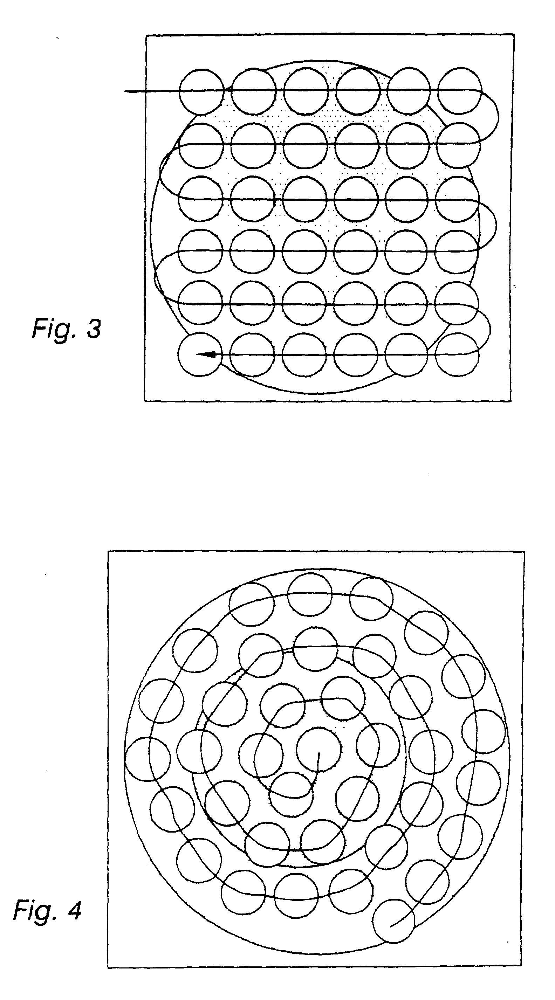

Pour optimiser la répartition du rayonnement, les détecteurs du réseau 1 peuvent être disposés selon plusieurs variantes, telles que celles proposées sur les figures 3 et 4.

Sur la figure 3, on a représenté un exemple de disposition classique des détecteurs. Selon ce mode de réalisation, les détecteurs forment un réseau carré, adressé séquentiellement en lignes et en colonnes. Sur cette figure, le rayonnement est représenté par un cercle moucheté et chaque rond blanc schématise un détecteur ; l'adressage est schématisé par la flèche.

Dans le cas d'un séquencement en lignes et en colonnes, si la tâche focale est réduite, alors les détecteurs situés aux extrémités du réseau de détecteur ne sont pas irradiés ; il n'y a donc pas d'information sur ces points de mesure, ce qui se traduit par un « trou » dans la restitution temporelle du signal. Ce problème peut être résolu en choisissant d'adresser les détecteurs selon une forme différente, comme celle montrée sur la figure 4.

Sur la figure 4, on a représenté des détecteurs disposés successivement en spirale, à partir du centre du réseau. Cette disposition permet d'ajuster la zone irradiée (schématisée par des « mouchetés ») et le nombre de points de mesure pour optimiser la sensibilité de détection. En réduisant la taille de la tâche de focalisation, on augmente la densité d'énergie sur les détecteurs et on diminue le nombre de détecteurs irradiés, donc le nombre de points de mesure. Ainsi, l'intervalle de temps entre deux échantillonnages successifs est configurable, ce qui permet de conserver la même fenêtre temporelle d'analyse.

## Revendications

1. Analyseur d'impulsion de rayonnement unique, **caractérisé en ce qu'**il comporte :
- une pluralité de détecteurs de rayonnement (2a,..., 2n) aptes à recevoir l'impulsion de rayonnement et à la transformer en une pluralité de signaux électriques ;
- une pluralité de moyens d'échantillonnage (11a,..., 11n) reliés chacun à l'un des détecteurs de rayonnement et aptes à échantillonner, à des instants différents, le signal électrique issu des détecteurs ;
- des moyens de retard (12a,..., 12n) reliés chacun à un moyen d'échantillonnage pour retarder d'un intervalle de temps, dt, l'instant d'échantillonnage entre deux moyens d'échantillonnage ;
- des moyens de stockage (13a,..., 13n) associés chacun à un moyen d'échantillonnage pour stocker les informations issues des détecteurs ; et
- des moyens (15) de lecture et de traitement de ces informations.

2. Analyseur selon la revendication 1, **caractérisé en ce que** les signaux électriques sont échantillonnés à autant d'instants différents qu'il y a de moyens d'échantillonnage.

3. Analyseur selon la revendication 1 ou 2, **caractérisé en ce que** les détecteurs sont associés sous forme d'un réseau à deux faces, polarisé par une électrode collective sur une face et une électrode individuelle sur l'autre face.

4. Analyseur selon l'une quelconque des revendications 1 à 3, **caractérisé en ce que** les détecteurs forment un réseau carré, adressé séquentiellement en lignes et en colonnes.

5. Analyseur selon l'une quelconque des revendications 1 à 3, **caractérisé en ce que** les détecteurs forment un réseau en spirale, adressé à partir du centre du réseau.

## Patentansprüche

1. Analysator eines einzelnen Strahlungspulses,
**dadurch gekennzeichnet, dass** er umfasst:
- eine Vielzahl von Strahlungsdetektoren (2a, ..., 2n), fähig Strahlungspulse zu empfangen und umzuwandeln in eine Vielzahl elektrischer Signale;
- eine Vielzahl von Abtasteinrichtungen (11a, ..., 11 n), jede verbunden mit einem der Strahlungsdetektoren und fähig, das von den Detektoren stammende Signal zu verschiedenen Zeitpunkten abzutasten;
- Verzögerungseinrichtungen (12a, ..., 12n), jede verbunden mit einer Abtasteinrichtung, um den Zeitpunkt der Abtastung zwischen zwei Abtasteinrichtungen um ein Zeitintervall dt zu verzögern;
- Speicherungseinrichtungen (13a, ..., 13n), jede verbunden mit einer Abtasteinrichtung, um die von den Detektoren stammenden Informationen zu speichern; und
- und Einrichtungen (15) zum Lesen und zum Verarbeiten dieser Informationen.

2. Analysator nach Anspruch 1, **dadurch gekennzeichnet, dass** die elektrischen Signale zu ebenso vielen verschiedenen Zeitpunkten abgetastet werden, wie es Abtasteinrichtungen gibt.

3. Analysator nach Anspruch 1 oder 2, **dadurch gekennzeichnet, dass** die Detektoren verbunden sind in Form eines Gitters mit zwei Seiten und auf der einen Seite durch eine kollektive Elektrode gepolt sind und auf der anderen Seite durch eine individuelle Elektrode.

4. Analysator nach einem der Ansprüche 1 bis 3, **dadurch gekennzeichnet, dass** die Detektoren ein quadratisches Gitter bilden, sequentiell nach Zeilen und Spalten adressierbar.

5. Analysator nach einem der Ansprüche 1 bis 3, **dadurch gekennzeichnet, dass** die Detektoren ein spiralförmiges Gitter bilden, das vom Zentrum des Gitters aus adressiert wird.

## Claims

1. Single radiation pulse analyzer, **characterized in that** it comprises:
- a number of radiation detectors (2a, ..., 2n) suitable for receiving the radiation pulse and transforming it into a number of electrical signals;
- a number of sampling means (11a, ..., 11n) each connected to one of the radiation detectors and capable of sampling the electrical signal output from the detectors at different times;
- delay means (12a, ..., 12n), each connected to sampling means to delay the sampling time between two sampling means by a time interval dt;
- storage means (13a, ..., 13n), each associated with a sampling means to store information output from the said sampling means; and
- means (15) of reading and processing this information.

2. Analyzer according to claim 1, **characterized in that** the electrical signals may be sampled at as many different times as there are sampling means.

3. Analyzer according to claim 1 or 2, **characterized in that** the detectors are associated in the form of a network with two faces, polarized by a collective electrode on one face and an individual central electrode on the other face.

4. Analyzer according to any one of the claims 1 to 3, **characterized in that** the detectors form a square network addressed sequentially in rows and columns.

5. Analyzer according to any one of the claims 1 to 3, **characterized in that** the detectors form a spiral network addressed from the centre of the network.
